(19) **Europäisches Patentamt European Patent Office Office européen des brevets**

(11) **EP 2 885 646 B1**

(12) **EUROPEAN PATENT SPECIFICATION**

(45) Date of publication and mention of the grant of the patent:
**26.07.2017 Bulletin 2017/30**

(21) Application number: **13879380.7**

(22) Date of filing: **22.05.2013**

(51) Int Cl.:
**G01R 31/34** *(2006.01)*    **G05B 13/02** *(2006.01)*

(86) International application number:
**PCT/IL2013/000050**

(87) International publication number:
**WO 2014/027339 (20.02.2014 Gazette 2014/08)**

(54) **SYSTEM AND METHOD FOR MONITORING AN ELECTRICALLY-CONNECTED SYSTEM HAVING A PERIODIC BEHAVIOR**

SYSTEM UND VERFAHREN ZUR ÜBERWACHUNG EINES ELEKTRISCH VERBUNDENEN SYSTEMS MIT EINEM PERIODISCHEN VERHALTEN

SYSTÈME ET PROCÉDÉ PERMETTANT DE SURVEILLER UN SYSTÈME CONNECTÉ ÉLECTRIQUEMENT POSSÉDANT UN COMPORTEMENT PÉRIODIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2012 US 201213567159**

(43) Date of publication of application:
**24.06.2015 Bulletin 2015/26**

(73) Proprietor: **Phase3 Technologies Ltd.**
**32626 Haifa (IL)**

(72) Inventor: **DAYAN, Prosper**
**26268 Kiriat-Chaim (IL)**

(74) Representative: **Hocking, Adrian Niall et al**
**Albright IP Limited**
**County House**
**Bayshill Road**
**Cheltenham, Glos. GL50 3BA (GB)**

(56) References cited:
**EP-A1- 1 298 511      IN-A1- 124M UM2 010**
**US-A- 5 576 632      US-A- 5 629 870**
**US-A1- 2010 169 030**

- **DA SILVA A M ET AL: "Induction Machine Broken Bar and Stator Short-Circuit Fault Diagnostics Based on Three-Phase Stator Current Envelopes", IEEE TRANSACTIONS ON INDUSTRIAL ELECTRONICS, IEEE SERVICE CENTER, PISCATAWAY, NJ, USA, vol. 55, no. 3, 1 March 2008 (2008-03-01), pages 1310-1318, XP011202577, ISSN: 0278-0046**
- **Ghasemi Shermineh: "Ryerson University An Application Of A Hybrid Wavelet-SVM Based Approach For Induction Motor Fault Detection Recommended Citation Ghasemi, Shermineh, "An Application Of A Hybrid Wavelet-SVM Based Approach For Induction Motor Fault Detection"", , 1 January 2010 (2010-01-01), XP055227995, Retrieved from the Internet: URL:http://digital.library.ryerson.ca/islandora/object/RULA:1474/datastream/OBJ/download/An_Application_Of_A_Hybrid_Wavelet-SVM_Based_Approach_For_Induction_Motor_Fault_Detection.pdf [retrieved on 2015-11-12]**
- **"LABVIEW FUNCTION AND VI REFERENCE MANUAL", INTERNET CITATION, 1998, XP007900533, Retrieved from the Internet: URL:http://www.ni.com/pdf/manuals/321526b.pdf [retrieved on 2006-03-23]**
- **SHERMINEH GHASEMI: 'AN APPLICATION OF A HYBRID WAVELET SVM BASED APPROACH FOR INDUCTION MOTOR FAULT DETECTION' 01 January 2010, XP055227995**

## Description

### FIELD AND BACKGROUND OF THE INVENTION

Embodiments of the current invention are related to a system and method for monitoring an electrically-connected system having a periodic behavior and for identifying deficiencies in such an electrically-connected system.

In the specification and claims which follow, the expression "electrically-connected" is intended to mean any electrical or mechanical device or system which is a) electrically powered; b) provides/generates electrical power; or c) has characteristics of a combination of being electrically powered and providing electrical power. Exemplary electrically-powered devices/systems include, inter alia, motors and lighting devices. Exemplary electrically-generating devices include, inter alia, generators and turbine systems. Exemplary combination electrically powered and electrically generating systems include, inter alia, hybrid vehicles as known in the art. In the specification and claims which follows, the terms "motor" and "machinery" are intended to mean the electrically powered devices/systems, as noted hereinabove.

Various diagnostic systems have been developed for the early warning of fault detection in electrically-connected rotating machinery/equipment. Many of these diagnostic systems include accelerometers, to collect the mechanical vibrations/waves emitted by the rotating machine, and a control unit to numerically analyze collected waves in the frequency domain. The diagnostic systems typically comprise a sensor or a plurality of sensors and a control unit, as known in the art. The sensors are usually positioned in the vicinity of the rotating parts to be diagnosed, or upon the rotating parts themselves, and the sensors are typically connected electrically to a control unit via cables/wires. As a result, such monitoring/diagnostic systems require a large space within the machinery "envelope", which represents an additional space burden for the machinery/equipment.

Examples of diagnostic systems are described in PCT patent applications WO 04/017038 and WO 00/04359.

Recently, fault detection and diagnosis (FDD) methods have been developed that compare output signals of a complex system with an output signal obtained from a mathematical model of the same fault-free system. The comparison between the signals of the mathematical model and those of the complex system is quantified in terms of one or more "residuals", i.e. one or more values representing the difference between the two. An analysis of the residual is performed to determine a type of system fault. The analysis includes statistical methods employed to compare the residuals against a database of residuals for systems with known faults.

Until recently it has been difficult to obtain accurate, real-time models for multivariable systems, meaning systems having more than one input and/or one output. If the model of a system is not accurate, the residuals will reflect modeling errors that are very difficult to separate from the effect of actual faults.

Duyar Ahmet et al. in U.S. patent 6,014,598, describe a model based fault detection system and method for monitoring and predicting maintenance requirements of electric motors. The system includes a computer means coupled to sensors which provide continuous real-time information of the input voltage and current and motor speed. The system and method utilize a multivariable experimental modeling algorithm to obtain a mathematical description of the motor. The algorithm compares the modeled result with a measured result and quantifies the comparison in terms of a residual which is generated by subtracting the respective signals. A diagnostic observer analyzes the residual and determines if the motor is fault free or operating in a manner other than fault free. Upon detection of the impending fault, the diagnostic observer evaluates the measured variables of the motor, determines the deviation from the reference value and develops a diagnosis of the likely failed or failing component.

Parlos Alexander et al. in U.S. patent 6,713,978 and U.S. patent application 2003/0065634, describe a non-linear, semi-parametric neural network-based adaptive filter which is utilized to determine the dynamic speed of a rotating rotor within an induction motor, without the explicit use of a speed sensor, such as a tachometer. The neural network-based filter is developed using actual motor current measurements, voltage measurements, and nameplate information. The neural network-based adaptive filter is trained using an estimated speed calculator derived from the actual current and voltage measurements. The neural network-based adaptive filter uses voltage and current measurements to determine the instantaneous speed of a rotating rotor. The neural network-based adaptive filter also includes an on-line adaptation scheme that permits the filter to be readily adapted for new operating conditions during operations.

Parlos et al., in U.S. patent 6,590,362 and in US patent application 2003/0067277, describe a method and system for early detection of incipient faults in an electric motor. First, current and voltage values for one or more phases of the electric motor are measured during motor operations. A set of current predictions is determined via a neural network-based current predictor based on the measured voltage values and an estimate of motor speed values of the electric motor. A set of residuals is generated by combining the set of current predictions with the measured current values. A set of fault indicators is subsequently computed from the set of residuals and the measured current values. Finally, a determination is made as to whether or not there is an incipient electrical, mechanical, and/or electromechanical fault occurring based on the comparison result of the set of fault indicators and a set of predetermined baseline values.

Additionally, Parlos in U.S. 7,024,335, describes assessing the condition of a device includes receiving signals from a sensor that makes electrical measurements of the device. An expected response of the device is estimated in accordance with the received signals, and a measured response of the device is established in accordance with the received signals. An output residual is calculated according to the expected response and the measured response. The condition of the device is assessed by identifying a fault of the device in accordance with the output residual.

Other methods for monitoring electrical systems are disclosed in EP1298511 and US5576632, as well in DA SILVA A M ET AL., "Induction Machine Broken Bar and Stator Short-Circuit Fault Diagnostics Based on Three-Phase Stator Current Envelopes", IEEE TRANSACTIONS ON INDUSTRIAL ELECTRONICS, IEEE SERVICE CENTER, PISCATAWAY, NJ, USA, vol.55, no. 3, 1 March 2008 (2008-03-01), pages 1310-1318, XP011202577, and in Ghasemi Sherminah, "Ryerson University An Application Of A Hybrid Wavelet-SVM Based Approach For Induction Motor Fault Detection", 1 January 2010 (2010-01-01), XP055227995.

There is therefore a need to facilitate simplified and lower cost implementation of monitoring and identifying deficiencies in an electrically-connected system having a periodic behavior.

SUMMARY OF THE INVENTION

According to the teachings of the present invention there is provided a method for monitoring a system having an electrical connection, the connection having at least two phases and respective currents, the system having a periodic behavior, the method comprising the steps of: creating a current transformer-related database corresponding to component features of proper functioning of the system, the current database created during operation of the system or created in advance of system operation; connecting sensors to measure respective currents of two phases of the electrical connection and transferring the measured current information to a PC host; using the PC host to transform the measured currents to create initial current information whereby the initial current information includes: a normalized correlation frequency spectrum, derived from the cross power spectrum of the at least two phases; a non-trivial frequency spectrum derived from the normalized frequency spectrum; and a root-mean-square calculation of the non-trivial frequency spectrum; making an initial determination of a normal operation of the system, by performing an initial threshold check whereby the root mean-square of the non-trivial spectrum is compared to a threshold value derived from the current database, using the PC host, and stopping and giving an indication of a fault/abnormal system operation if the initial threshold check is not successful; operating the PC host to perform training and modeling of the system, following successful initial determination of normal operation of the system, the training and modeling including further current measurements yielding modeled current information; monitoring the system, including instant current measurements of the system and using the PC host to yield instant current information indicative of instant operation status of the system; and making an instant determination of operation status of the system by using the PC host to compare the instant current information with the modeled current information. Typically, no training, modeling, and monitoring of the system are performed when the initial threshold check is not successful. Most typically, the initial determination of normal operation of the system is completed in a time period ranging substantially from 30 to 180 minutes.

Preferably, modeled current information includes a coefficient vector and a training feature table. Most preferably, instant current information includes an instant feature table. Typically, a residual energy is calculated based on the instant current information and the modeled current information and the residual energy is compared to at least one threshold to make the instant determination of operation status. Most typically, training and modeling is completed in a time period ranging substantially from 36 to 100 hours.

According to the teachings of the present invention there is further provided a monitoring system for monitoring a system having an electrical connection, the connection having at least two phases and respective currents, the system having a periodic behavior, the monitoring system configured to use a current transformer-related database corresponding to component features of proper functioning of the system, the current database created during operation of the system or created in advance of system operation, the monitoring system comprising: at least two current sensors adapted to be connected to the at least two phases and to measure respective currents of the at least two phases; an A-to-D converter connectable to the current sensors and adapted to digitize the measured currents; a PC host connectable to the A-D converter and adapted to process the digitized measured currents to: create initial current information indicative of initial normal operation of the system; make an initial threshold determination of a normal operation of the system, by performing an initial threshold check whereby the root mean-square of the non-trivial spectrum is compared to a threshold value derived from the current database, using the PC host, and stopping and giving an indication of a fault/abnormal system operation if the initial threshold check is not successful; perform training and modeling of the system, following the successful initial determination of normal operation of the system, to yield modeled current information; and monitor the system with instant current measurements to yield instant current information indicative of instant operation status of the system wherein the monitoring system is adapted to make a determination of instant operation status of the system based on a comparison of the instant current information with the modeled current information. Typically, the initial current information includes: a normalized correlation frequency spectrum; a non-trivial frequency spectrum derivable from the normalized frequency spectrum; and a root-mean-square calculable from the non-trivial frequency spectrum. Preferably, the indication of initial normal operation of the system is completable in a time period ranging substantially from 30 to 180 minutes.

Most preferably, modeled current information includes; a coefficient vector and; a training feature table. Typically, instant current information includes and an instant feature table. Most typically, a residual energy is calculable, based on the instant current information and the modeled current information. Preferably, the instant operation status of the system is determinable based upon a comparison of the residual energy and at least one threshold.

BRIEF DESCRIPTION OF THE DRAWINGS

The invention is herein described, by way of example only, with reference to the accompanying drawings, wherein:

FIG. 1 is an illustration of a system for electric pump fault detection according to the Prior Art;
FIG. 2 is a schematic flowchart of steps in a monitoring system, in accordance with an embodiment of the present invention;
FIG. 3 is a schematic flowchart of a preamplifier, an A-to-D converter, a control unit and a communication unit, integrated into an autonomous unit in accordance with an embodiment of the present invention;
FIGS 4- 6 are flow diagrams serving, together, to describe a method of monitoring an electrically-connected system having a periodic behavior, in accordance with an embodiment of the present invention; and
FIGS. 7-11 are plots of coherence versus frequency, showing a normal operation (FIGS. 7-8) and an abnormal operation (FIGS. 9-11) of an exemplary electric motor, as part of the initial threshold check of FIG 4 of the monitoring system, in accordance with embodiments of the current invention.

DETAILED DESCRIPTION OF EMBODIMENTS

Embodiments of the current invention are related to a system and method for monitoring an electrically-connected system having a periodic behavior and for identifying deficiencies in such an electrically-connected system-such as, but not limited to, an electric motor.

Embodiments of the present invention additionally provide a novel stand- alone monitoring system, integrating two ROGOWSKI current transformers fixed together with the monitoring system in the vicinity of the electrical board of an electrically-powered system. The integrated current transformers eliminate a need for wire/cable connection and facilitate placement of the monitoring system equipment along with or remotely from the monitored system. The monitoring system can perform signal measurement and analyses (using an industrial processor) and results can be directly transmitted (via wires or wireless means) to a central station location. The monitoring system of embodiments of the invention comprises an autonomous electronic system which may be mounted as a stand-alone unit configured to remotely monitor an electrically-connected system.

Therefore, there is provided an autonomous electronic system, which may be used to exemplarily monitor an electrically-connected system. The system comprises two current sensors outputting two respective analog two-phase signals (from the 3 phase AC electrical power supply) indicative of the operation of the rotating part; a preamplifier; an Analog-to-Digital (A-to-D) converter configured to receive the analog signals from the current sensors; a control unit configured for applying a spectral analysis to the signal outputted by the A-to-D converter to determine an abnormality in the operation of at least one of the rotating parts, and a communication unit configured to transmit a final diagnosis result, wherein the 2 current transformers (sensors), the preamplifier, the A-to-D converter, the control unit, and the communication unit are mechanically integrated parts and form a single autonomous unit.

In some embodiments of the current invention, the control unit comprises hardware and/or software modules.

Embodiments of the current invention include a system configured to monitor any electrically-connected devices and system having a periodic behavior, such as, but not limited to machinery having a periodic behavior. Examples of such systems are power plants, wind turbines, any turbine (jet, fan, prop), combustion and electrical engines, generators, gearboxes, accessories such as pumps, fan coolers, compressors, rotors, rotor blades, shafts, bearings, inter alia.

Embodiments of the current invention include the monitoring system being configured to detect deficiencies such as mechanical faults such as, but not limited to: shaft imbalance; foreign object damage (FOD) ; internal object damage (IOD) ; wheel tooth fracture; wheel tooth wear; housing fracture/deformation; bearing races pitting/spalling; bearing cage fracture; ball bearing seizure; chips; coupling cracks; blade fracture/deformation/cracks; and support fracture-all at an early stage before serious failures. The system can also be utilized for emergency early warning and for Condition Based Maintenance (CBM).

According to another broad aspect of embodiments of the present invention, a method is provided for creating a current transformer-related database corresponding to component features of proper functioning of a device or system; sensing electrical current measurements corresponding to mechanical vibrations produced by individual parts of a mechanical system during operation; comparing the sensed measurements with the current database using narrow band spectral analysis; and identifying the device or specific part of the system in which malfunctions occur and the type of malfunction. In the specification and claims which follow hereinbelow, the term "component feature" is intended to mean a characteristic amplitude-frequency behavior associated with a respective mechanical component of a system or of a device. Every frequency has its respective energy level, taken from the entire frequency spectrum.

According to another embodiment of the current invention, sensed current values, corresponding to indications of a malfunctioning component are also included in the current database. The current database can also be created during operation of a mechanical system, rather than being entered in advance. Health measures indicating the development of an impending malfunction can be transmitted (wirelessly or by wire) to a central control station or to a responsible person to take proper action.

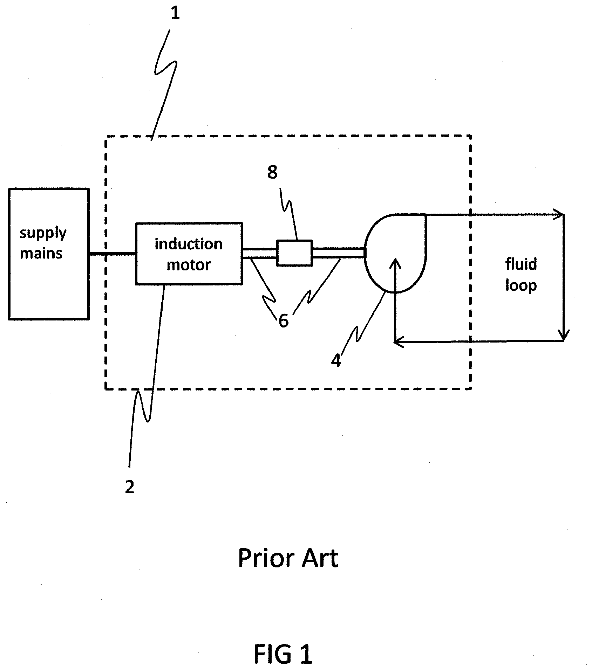

Reference is currently made to FIG 1, which is an illustration of a system **1** for electric pump fault detection, according to the Prior Art. System **1** comprises a driver -which is an induction motor **2**- and a driven load which is a centrifugal pump **4,** which typically circulates a fluid. Pump **4** is connected to motor **2** by means of shafts **6** and a mechanical coupling **8.** If motor **2** and pump **4** are both "healthy", system **1** performs as per design specifications, and an output of motor **2** (i.e. torque) would be as per the specifications. Similarly, in a healthy system, outputs of pump **2,** namely a flow rate and a pressure difference, would be as per characteristics curves of pump **4** provided by the manufacturer.

However, if motor **2** has a fault, the output torque may be the same as compared to that of a normal (i.e. "healthy") motor but the output torque of the faulty motor has extra harmonics correlating to the fault. Similarly, if pump **4** is not healthy, then it does not produce a required work (i.e., horsepower). Moreover, the torque transmitted from motor **2** to pump **4** is also influenced by the speed of pump **4.** Hence, a fault in either pump **4** or motor **2** has an effect on the torque produced by the induction motor. Any changes in the torque of motor **2** are reflected in changes in the currents (not indicated in the figure) of motor **2.**

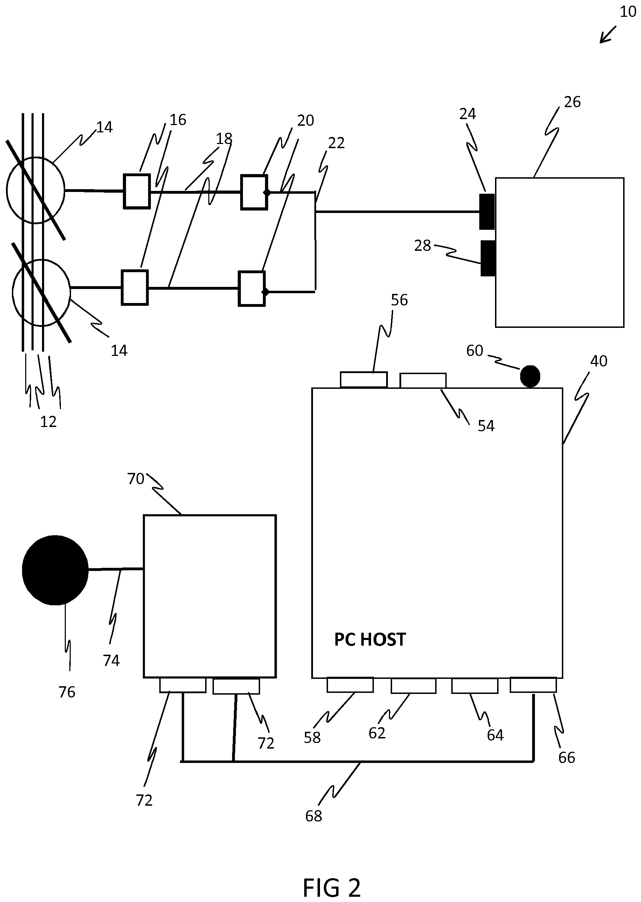

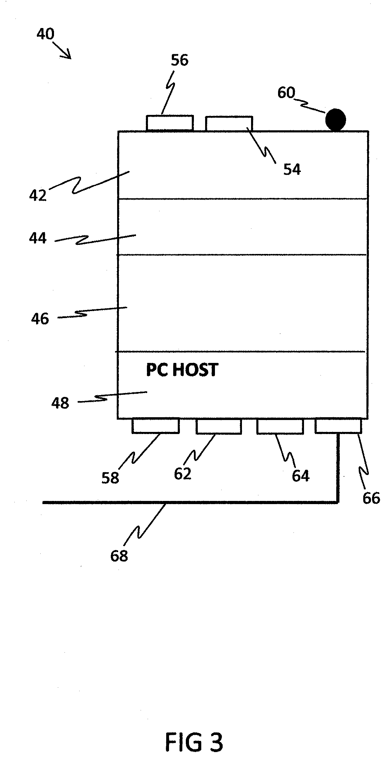

Reference is made to FIGS. 2 and 3, which are schematic block diagrams of a monitoring system **10,** and details of PC host **40,** in accordance with embodiments of the present invention. In the specification and claims which follow, the expression "PC host" is intended to mean any computing device as known in the art including, but not limited to: a desk top computer; a laptop computer; a smartphone; and a server computer.

Monitoring system **10** may be used for monitoring electrically-connected equipment having periodic behavior-such as, but not limited to electro-mechanical having at least one rotating part. An exemplary application of monitoring system **10** is to monitor an electrically powered motor -not shown in the figures.

Monitoring system **10** is configured as a standalone unit, directly attachable to or located in the vicinity of an electrical board (not shown in the figures) which belongs to a mechanical system and the monitoring system can sense and analyze signals (e.g. using an industrial processor without moving parts) and produce results, all as described hereinbelow.

System **10,** according to one broad embodiment of the present invention, measures AC current using two current sensors **14 -** current transformers (e.g. ROGOWSKI coils) for measuring current from distribution lines **12** of the electromechanical powered system, for example, a 3-phase electrical motor (not shown in the present figure, but similar to motor 2 of FIG 1). Current sensors **14** have a frequency response in a range of about 10Hz to 50,000 Hz. Current sensors **14** are equipped with two safe sockets **16** for ROGOWSKI coil cable ends and are connected by cables **18** having a length of approximately 1 meter to a BNC socket **20** and further to an adaptor **22.** Adaptor **22** is made as a 2 x BNC-to-PL two adaptors (high quality with Ferrite). Adaptor **22** is connected by a microphone socket **24** to USB Sound Card **26,** which also has a headphone socket **28.**

According to a preferred embodiment of the present invention, PC host **40** is a TQ-Mini unit and schematically consists of: a preamplifier **42,** an A-toD converter **44** (e.g. sampling card), a control unit **46** (e.g. processor or microprocessor) and a communication unit **48** (e.g. wireless communication card), for transmitting final results, as described further hereinbelow.

PC host **40** is supplied with USB sockets **54, 56, 58,** a light signal **60,** a VGA outlet **62,** a LAN outlet **64** and a power inlet **66** for a DC 5V small USB. A USB Cord **68** connects small USB Power inlet **66** with a transformer **70** (typically 5V DC) via a USB splitter **72-** two USB inlets. Transformer **70** is connected by a wire **74** having a plug **76,** for electrical supply to PC host **40.** Exemplary electrical supply value is 110 and 220V AC. Monitoring system **10** can be connected to a DC power supply (not shown in the figures).

Current sensors **14** are an integrated part of monitoring system **10.** Cables **18,** having a typical length ranging from 0.5 to 2.0 m, but less than approximately 3 m are used. One of the advantages of the configuration shown in FIGS 2 and 3 is that only one location of system **10** is required within device or system being monitored-generally yielding, inter alia, shorter cabling lengths, as opposed to much larger devices for monitoring, based on accelerometers.

In some embodiments, system **10** does not have moving parts so as to avoid internal background noise and vibrations. Likewise, control unit **46** has a flash memory (not shown in the figure)-as opposed to a hard drive - and control unit **46** can be configured without a cooling fan for its processor. Control unit **46** serves to identify the presence of failures and/or of faulted mechanical components of the monitored system/device, and to give earlier alerts for possible future failures using spectral analysis-as further described hereinbelow.

Monitoring system **10** is placed near the monitored system/device being monitored (referred to alternatively hereinbelow as "machinery") and performs the following operations, as further described hereinbelow:

    a) Measurement of incoming currents feeding the machinery;
    b) Analyses of the spectral features of current measurements;
    c) Performing a decision process ("normal"/"abnormal" operation); and
    d) Sending results to a central station (i.e. control center-not show in the figures)

In some embodiments, of the current invention, to compensate measured sound level spectral features, monitoring system 10 has an optional data collection bus (not shown in the drawings) originating from the machinery. Examples of data collected are: rotation speed, torque, air velocity, ambient pressure, ambient temperature, elevation/altitude, fuel consumption, pitch roll or yaw angles, speeds or accelerations, inter alia.

Monitoring system **10** can include a data acquisition card with an anti-aliasing filter. The data acquisition module can be configured as a high performance sound and vibration A-to-D measurement card. The data acquisition card is a Peripheral Component Interconnect (PCI) connected to a PCI slot in the fan-less industrial processor but can be also connected via USB **54.**

Communication unit **48** serves to deliver a final diagnosis result to control unit 46 via wire or a wireless connection. The wireless connection can be configured as an IEEE 802.11n WLAN, or RF transmitter/receiver, GPRS, or satellite communication. Control unit **46** can be monitored via a remote connection through communication unit **48.** The technique of monitoring can also be updated via communication unit **48.**

As noted previously, the output of preamplifier **42** delivers signals to Analog-to-Digital (A-to-D) converter **44** configured to receive these analog signals from current sensors **14.** Output signals of current sensors **14** are sampled and converted to a series of digital signals by an analog to digital (A-to-D) converter **44** having a suitable sampling frequency. Then digital signals are delivered to control unit **46,** which is configured for applying a spectral analysis to the signal outputted by A-to-D converter **44** to determine an abnormality in the operation of at least one of the electromechanical machine rotating parts. Analog to digital (A-to-D) converter **44** is coupled to a microprocessor (not shown in the figure) of control unit **46** where the sampled data are stored for a predetermined period. Control unit **46** then analyses the delivered signal in comparison with the data received from the mentioned electrical-related database using mathematical and statistical tools (e.g. narrow band spectral analysis) and identifies a specific part of the machinery with malfunctions and identifies the type of deficiency.

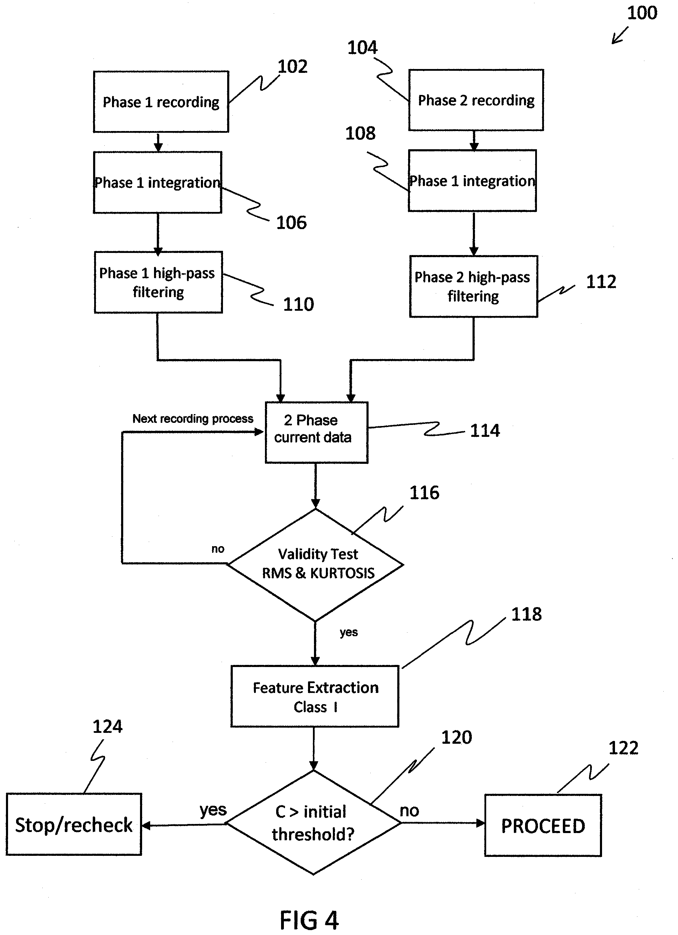

Reference is presently made to FIGS 4-6, which are flow diagrams serving, together, to describe a method of initially checking and then monitoring an electrically-connected system having a periodic behavior, such as, but not limited to, a rotating part of a mechanical system, in accordance with embodiments of the present invention. The method is described hereinbelow, with reference to elements identified in FIGS 2-3.

In FIG 4 is a schematic flowchart showing algorithm **100,** which is a series of steps performed to initially determine whether the system being monitored (in this case, a motor) is considered "normal" or" not normal". The determination is important because subsequent monitoring steps are valid only when compared to a "normal" system. Should the system be initially determined as "not normal", the system must then be further checked and/or other actions may be necessary.

Algorithm **100,** which including a step referred to hereinbelow as "initial threshold check", preferably takes a number of minutes and typically less than a few hours to complete-as opposed to other prior art methods which could take days to complete. The significantly reduced time for the determination of "normal"/"not normal" system, in accordance with embodiments of the current invention, not only saves time and resource allocation, but also intrinsically contributes to a more reliable determination-as the system itself my undergo changes during extended testing/sampling.

In algorithm **100,** steps **102** and **104,** Phase 1 recording and Phase 2 recording, respectively, analog signals from the alternating current supply for two current phases of an exemplary 3-phase motor (not shown in the figures) are recorded, as described hereinabove in FIGS 2 and 3. Respective recorded analog signals are then converted to discrete current signals in A-to-D converter **44** to which constant parameters are applied. The parameters characterize the process of conversion of analog signals to discrete signals, i.e. the sampling/monitoring rate and the time period of the signal subjected to conversion, as known in the art. A typical monitoring rate may be 50 KHz, and a typical time period for sampling may range from approximately 1 to 24 seconds, with an optimal time period of approximately 12 seconds.

In respective steps **106** and **108,** Phase 1 integration and Phase 2 integration, respectively, recorded digital signals from previous respective steps **102** and **104** are currently integrated, to obtain digital values representing the actual respective currents. Following this, in steps **110** and **112,** Phase 1 high pass filtering and Phase 2 high pass filtering, respectively, are performed on the integration results to effectively remove DC effects from integration, as known in the art. This yields "2 phases of current data" (i.e. initial, digitized current data from 2 phases, before subsequent mathematical manipulation and analyses, as described hereinbelow) in step **114,**

In step **116,** Validity Test RMS & Kurtosis, digital current data from the 2 phases of current data of step **114** are statistically transformed, as known in the art-where RMS is the 2nd moment and Kurtosis is the 4th moment of the current data. A validity test result is assessed as "Yes" or "No", as known in the art.

If the validity test result of step **116** is "No", control is returned to step **114** and the next signal recording is evaluated. If the validity test result of step **116** results is "Yes", then the present signal results are passed to **step 118,** Features Extraction Class 1, according to the following operations:

a. Using the last recorded measured digital current values, a normalized correlation $C_{12}(f)$, frequency spectrum is created, as known in the art, according to:

$$C_{12}(f) = | P_{12}(f)|^2 \; / \; P_{11}(f) \, P_{22}(f)$$

Where:

$f$ = frequency
$P_{12}$ = cross power spectrum of the two signals, phase1 and phase2
$P_{11}$ = power spectrum of phase 1
$P_{22}$ = power spectrum of phase 2

b. Features are then extracted from the above frequency spectrum corresponding to trivial frequencies and a root-mean-square is then calculated for the resultant spectrum, schematically according to the relation:

$$C = RMS \left( \Sigma \; c \; _{non\text{-}trivial\;frequencies} \right)$$

The normalized correlation frequency spectrum, the frequency spectrum having corresponding trivial frequencies extracted and the root-mean-square calculation, all as described hereinabove, are collectively referred to hereinbelow as "initial current information".

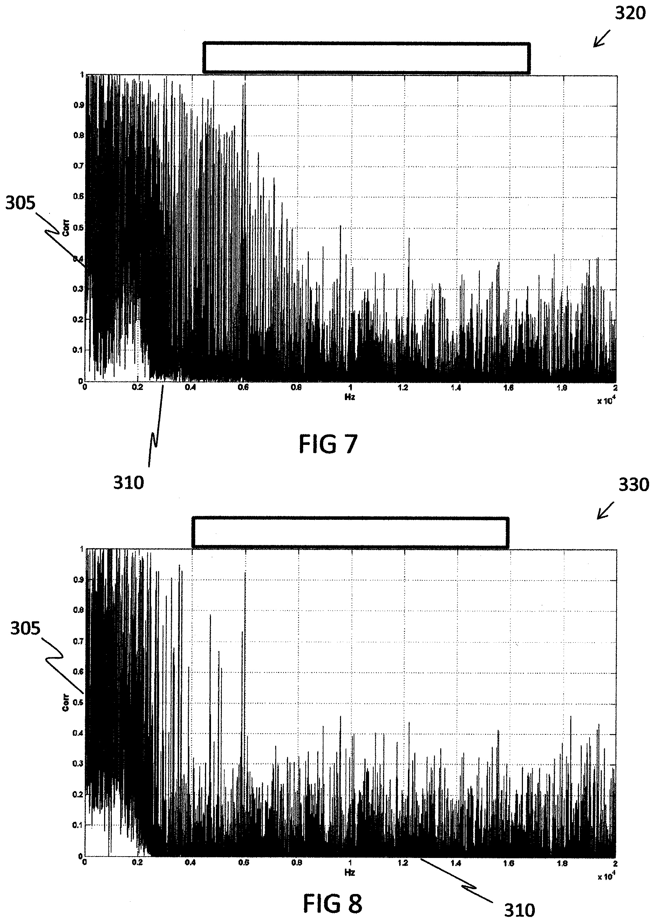

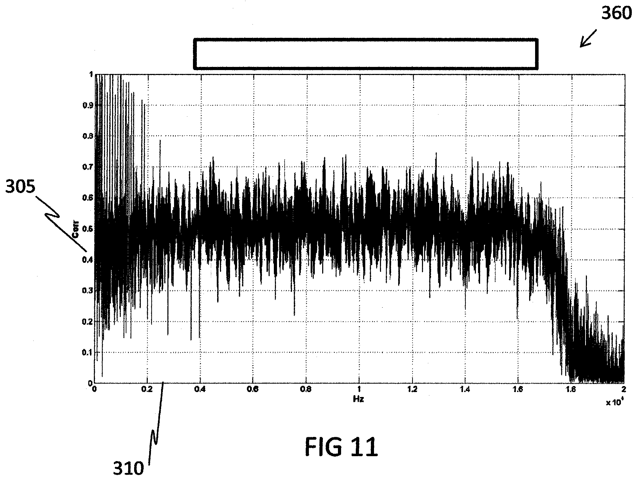

After step **118,** control is transferred to step **120,** C > initial threshold. Step **118** is also referred to in the specification and claims with follow hereinbelow as an "initial threshold check". (Additional discussion of the initial threshold, including examples, follows hereinbelow in description of FIGS 7-11.)

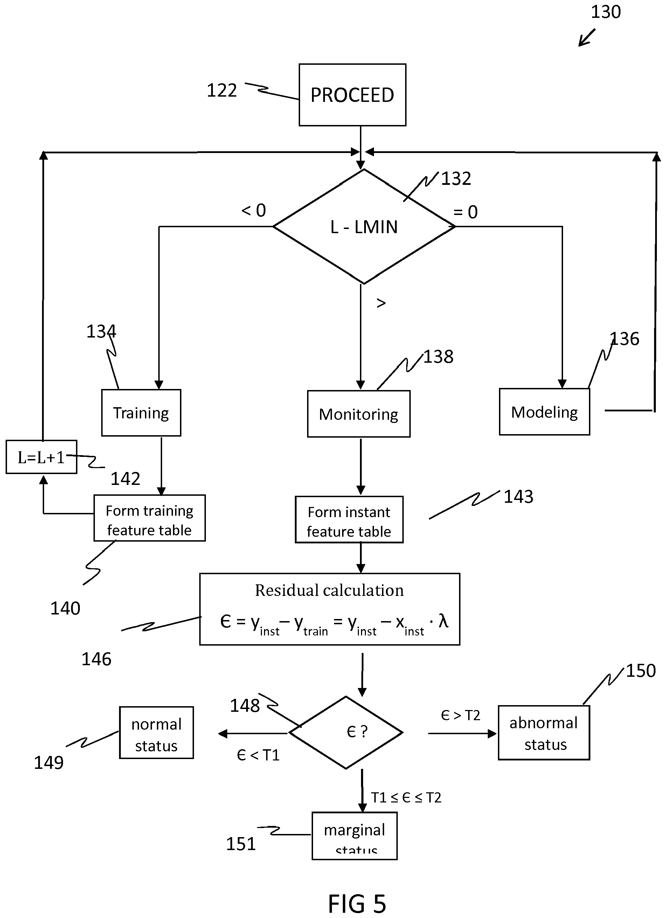

If the answer to "C > initial threshold?" is "no" in step **120,** then the monitored motor is OK, and the initial threshold check is successful. Control is transferred to step **122,** PROCEED. Training, modeling, and routine monitoring of the system being monitored presently take place, as described hereinbelow in algorithm **130,** shown in FIG 5.

If the result of step **120** is "yes", the monitored motor is not OK (i.e., the initial threshold check is not successful) and control is transferred to step **124,** Stop/recheck. An alarm and/or another indication (not shown in the figures) of a fault/abnormal operation of the motor is initiated. No further training/testing of the motor is performed until after the problem is found. When and if the problem is found, algorithm 100 is restarted with steps 102 and 104. Performance of the initial threshold check serves to save expending valuable resources and time training a motor that does not initially exhibit normal characteristics.

In another embodiment of the current invention, step 124 may include one or more additional thresholds as described hereinbelow with reference to FIGS 7-11.

Referring presently to FIG 5, algorithm **130** includes iterative steps (indicated by the integer value "L") to first train, then model, and to then routinely monitor the exemplary motor, in accordance with embodiments of the current invention.

In step **132** a calculation of L- $L_{min}$ is made where the value $L_{min}$ is an integer vale representing the minimum steps necessary for training.

$L_{min}$ is typically determined empirically from previous training attempts and/or from time and computing constraints. For example, $L_{min}$ may be determined to be the number of steps that yield approximately 48 to 96 hours of training and modeling. In the case of electric motors, typical values of $L_{min}$ may range from 50 to 200.

Three possible results for the calculation in step 132 are:

L - $L_{min}$ < 0, "training"; control is transferred to step **134;**
L - $L_{min}$ = 0, "modeling"; control is transferred to step **136;** and
L - $L_{min}$ > 0, "monitoring"; control is transferred to step **138.**

Training -step **134**

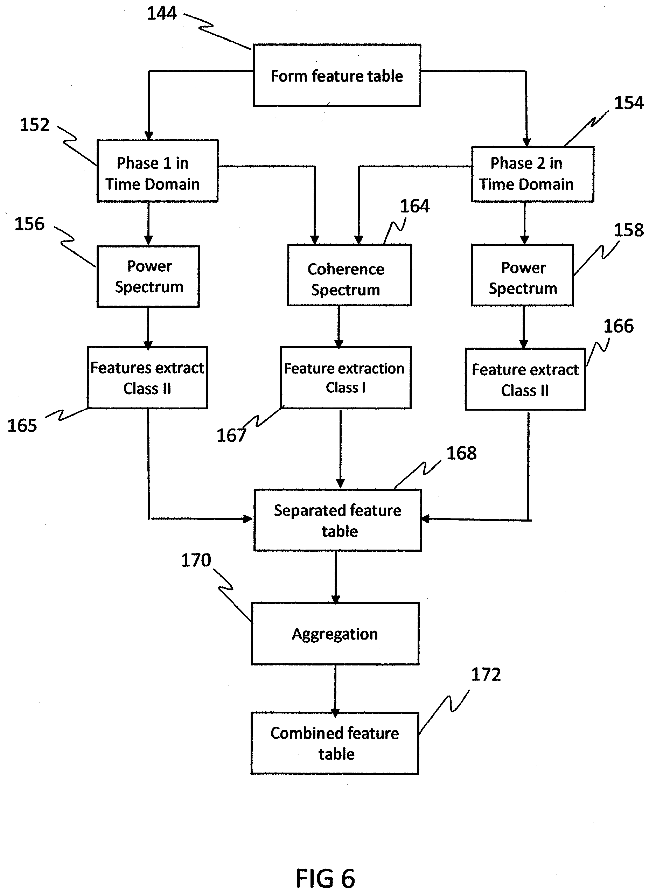

The result of L - $L_{min}$ < 0 in step **132** yields continued training in step **134.** Training is the first activity performed (typically repeated numerous times) to "teach" the algorithm specific features/characteristics of the signal of the previously-determined "normal" motor. Control is transferred to step **140,** Form training feature table, as described hereinbelow in FIG 6. (A training feature table is formed on the first iteration and successive spectrum information is added to it in each successive iteration.) Following step **140,** L is incremented in step **142,** L = L + 1. Control is then returned to step **132** for another L- $L_{min}$ calculation, as described hereinabove.

Modeling -step **136**

When the result in step **132** of L - $L_{min}$ = 0, iterative training steps have been completed and a one-time modeling step is performed in step **136,** Modeling. Modeling involves calculating one-dimensional second order and two dimensional second order polynomial coefficients from the training feature table of the previous step.

This yields a coefficient vector (λ). The coefficient vector and the training feature table are collectively referred to hereinbelow as "modeled current information". The modeled current information serves as baseline information during subsequent routine monitoring (described hereinbelow) against which to compare instant operation status of the system being monitored.

Monitoring -step **138**

Following modeling step 136, control is then returned to step **132** for another L- $L_{min}$ calculation. When the result in step **132** of L - L $_{min}$ > 0 (i.e. starting with the iteration immediately following modeling) training and modeling steps described hereinabove are complete. Control is transferred to step 138, Monitoring, which includes, inter alia, instant current measurement and transformations, similar to those described hereinabove for the training step to determine an instant operation status, as described hereinbelow.

In step **143,** Form instant feature table, data from the instant current measurements (similar to steps **102** through **116,** as described hereinabove in FIG 4) are used to form an instant feature table, as described hereinbelow in FIG 6. The instant feature table is referred to hereinbelow as "instant current information".

Following step **143,** a residual calculation is then performed in step **146,** according to the relation, as known in the art:

$$\epsilon = y_{inst} - y_{train} = y_{inst} - x_{inst} \cdot \lambda,$$

where:

| | |
|---|---|
| $\epsilon$ | residual energy |
| $y_{inst}$ | energy calculated from instant monitoring |
| $y_{train}$ | energy calculated from training |
| $x_{inst}$ | parameter matrix calculated from instant monitoring |
| $\lambda$ | coefficient vector obtained from modeling |

At this point, control in algorithm **130** proceeds to step **148,** "$\epsilon$ ?" , where the value of residual energy calculated in step **146** hereinabove is evaluated with regard to two threshold values, T1 and T2. T1 is a first value, typically corresponding to $4\sigma$ value of a residual distribution, as known in the art. Likewise, T2 is a second value, typically corresponding to $8\sigma$ value of a residual distribution, as known in the art.

Possible results are:

$\epsilon$ < T1 -yielding step **149,** normal (the motor is evaluated as having a "normal" operation status);
$\epsilon$ > T2 -yielding step **150,** abnormal (the motor is evaluated as having an "abnormal" operation status); and

T1 < $\epsilon$ <T2 -yielding step **151,** abnormal (the motor is evaluated as having a "marginal" operation status).

Typically, following step **149** ("normal") control in algorithm **130** may be transferred to step **138,** to continue routine monitoring of the motor. Alternatively, monitoring may be presently stopped. Algorithm **130** may be initiated at step **138,** when it is desirable to again continue routine monitoring of the motor.

Typically, following steps **150** ("abnormal") and **151** ("marginal") control in algorithm **130** may be transferred to step **138,** to continue routine monitoring of the motor. However, because either an "abnormal" or "marginal" motor condition has been identified, more typically, motor operation is curtailed or stopped to perform motor maintenance/repair/replacement work and routine monitoring is likewise curtailed or stopped.

Reference is currently made to FIG 6, which starts with step **144,** Form feature table. Step **144** is essentially equivalent to steps **140** and **143,** both previously mentioned in FIG 5 with regard to training and to routine/instant monitoring. Feature extraction is known in the art and the following steps are summarized for purposes of clarity.

Current signals recorded in Phase 1 Time Domain, step **152,** and Phase 2 Time Domain, step **154,** serve to describe parameters of the exemplary 3-phase motor being monitored. The signals are compared with the respective power spectrums in steps **156** and **158,** and the respective Features extraction Class II in steps, **165** and **166**-which are equivalent steps (but refer, respectively, to phase 1 and phase 2 information). Energies of specific frequencies defined and are then calculated according to the expression:

$$\int_i y df \; ;$$

where $\int_i$ **ydf** is the integral of *y* spectra as a function of the frequency *f* at all i features.

In parallel, as indicated in the figure, following steps **152** and **154,** a coherence spectrum is formed in step **164** and feature extraction class 1 is performed in step **167,** in identical fashion to both steps performed and described hereinabove in step **118** of FIG 4.

The two values corresponding to Feature extraction Class I of Step **167** are recorded in separated feature table in step **168.** The separated feature table of step **168** also contains the features extracted from steps **165** and **166,** as described hereinabove.

Values from the tabulated features extracted in steps **165** and **166** are then aggregated in step **170** Aggregation, to yield aggregated data, as known in the art. The resultant data is then recorded, in step **172,** to yield a combined feature table, which includes the aggregated data and the two values corresponding to feature extraction Class I of Step **167,** hereinabove.

Following step 170, control is reverted back to steps **140** and **143** of FIG 5.

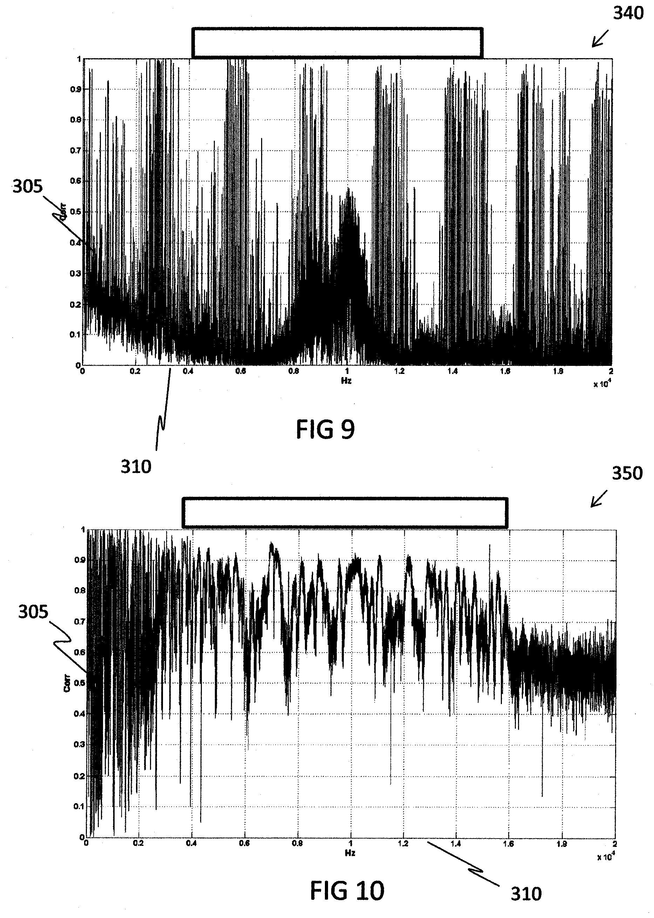

Reference is made to FIGS 7-11, which are spectral coherence plots expressed in coherence **305** (abbreviated as "corr" in each plot) versus frequency **310,** as part of the initial threshold check, as described in FIG 4 hereinabove, in accordance with embodiments of the current invention. The spectral plots include those of: normal initial operation (plots **320** and **330** of FIGS.7 and 8) and; abnormal initial operation status (plots **340, 350,** and **360** of FIGS. 9-11) of an exemplary electric motor.

The values of coherence **305** shown range from 0 to 1 while the values of frequency **310** range from 0 to 2 x 10⁴ (i.e. 20,000) Hz.

The plots shown in FIGS 7 - 11 are based on the calculation of normalized correlation $C_{12}(f)$, as described hereinabove in step 118 of FIG 4.

It can be seen that in normal initial operation (plots **320** and **330** of FIGS. 7 and 8) the coherence of 2 phases is naturally high at the trivial frequencies (for example: harmonics of an exemplary 50Hz supply frequency i.e. 50, 100, and 150Hz, etc.) while at other frequencies, the coherence has lower values.

In plots **340, 350,** and **360** of FIGS. 9-11, representing abnormal initial operation status of the motor, coherence at non-trivial frequencies is high, indicative of irregular operation on both phases simultaneously. The high coherence values of non-trivial frequencies in plots **340, 350,** and **360** are much more significant than coherence levels of plots **320** and **330.**

An RMS calculation may be made for each of the plots described hereinabove according to the expression:

$$RMSC = \sqrt{(\int C_{12}(f)\, df\,)}$$

Where *f* is evaluated between 0 and 400 orders (evaluated at a base frequency of 50Hz, thereby yielding a range of 0 to 20kHz) and only the non-trivial frequencies are included, meaning all frequencies except 50Hz harmonics.

Referring again to FIG 4, steps **122** and **124** respectively refer to successfully passing the initial threshold check and unsuccessfully passing the initial threshold check. Alternatively or alternatively, step 124 (stop/recheck) may be further subdivided to two steps not shown in thee figure: recheck; and stop, as discussed further hereinbelow.

It has been found that a direct determination of normal, marginal, and abnormal motor operation may be made from the RMSC values of plots similar to those shown and described in FIGS 7-11 hereinabove, where:

RMSC < 5 is indicative of a normal operation (i.e. step **122** of FIG 4);

5 ≤ RMSC ≤ 10 is indicative or marginal operation; and

RMSC > 10 is indicative of abnormal operation.

Embodiments of the monitoring system of the current invention have the following advantages:

- No physical intervention or installation on the monitored machinery;
- Relatively short learning period of the equipment is required;
- No kinematic parameters of the rotating parts is required;
- No need for RPM and voltage measurements;
- Ability to diagnose new motors and repaired motors;
- Provide near- immediate information regarding the monitored system following connection of the monitoring system;
- The monitoring system has an electrical supply backup in case of electrical shutdown
- Logging all raw data for at least two years
- Need only two current sensors, obtaining higher performance and high sensitivity by using a physical model for cancelling load and environmental influence, and
- The monitoring system is mounted in the monitored system electrical board, with no need for the monitoring system to be located at/next to the monitored system and/or shutting down the monitored system.

It is emphasized that whereas the system monitored by the monitoring system has been described hereinabove as an exemplary electrical motor and/or rotating equipment, embodiments of the current invention include monitoring any electrically-connected device or system which is: a) electrically powered; b) provides/generates electrical power; or c) has characteristics of a combination of being electrically powered and providing electrical power.

It will be appreciated that the above descriptions are intended only to serve as examples, and that many other embodiments are possible within the scope of the present invention as defined in the appended claims.

**Claims**

1. A method for monitoring a system having an electrical connection, the connection having at least two phases and respective currents, the system having a periodic behavior, the method comprising the steps of:

creating a current transformer-related database corresponding to component features of proper functioning of the system, the current database created during operation of the system or created in advance of system operation;

connecting sensors (14) to measure respective currents of two phases of the electrical connection and transferring the measured current information to a PC host (40);

using the PC host (40) to transform the measured currents and to create initial current information whereby the initial current information includes: a normalized correlation frequency spectrum, derived from the cross power spectrum of the at least two phases; a non-trivial frequency spectrum derived from the normalized frequency spectrum; and a root-mean-square calculation of the non-trivial frequency spectrum;

making an initial determination of a normal operation of the system, by performing an initial threshold check whereby the root mean-square of the non-trivial spectrum is compared to a threshold value derived from the current database, using the PC host (40), and stopping and giving an indication of a fault/abnormal system operation if the initial threshold check is not successful;

operating the PC host (40) to perform training and modeling of the system, following successful initial determination of normal operation of the system, the training and modeling of the system including further current measurements yielding modeled current information;

monitoring the system, which includes performing instant current measurements of the system and using the PC host (40) to yield instant current information indicative of instant operation status of the system; and

making an instant determination of operation status of the system by using the PC host (40) to compare the instant current information with the modeled current information.

2. The method of claim 1, whereby no training, modeling, and monitoring of the system are performed when the initial threshold check is not successful.

3. The method of claim 1, whereby the initial determination of normal operation of the system is completed in a time period ranging substantially from 30 to 180 minutes.

4. The method of claim 3, whereby modeled current information includes a coefficient vector and a training feature table.

5. The method of claim 4, whereby instant current information includes an instant feature table.

6. The method of claim 5, whereby a residual energy is calculated based on the instant current information and the modeled current information and the residual energy is compared to at least one threshold to make the instant determination of operation status.

7. The method of claim 1, whereby training and modeling is completed in a time period ranging substantially from 36 to 100 hours

8. A monitoring system (10) for monitoring a system having an electrical connection, the connection having at least two phases and respective currents, the system having a periodic behavior, the monitoring system:

configured to use a current transformer-related database corresponding to component features of proper functioning of the system, the current database created during operation of the system or created in advance of system operation, the monitoring system comprising:

at least two current sensors (14) configured to be connected to the at least two phases and to measure respective currents of the at least two phases;

an A-to-D converter connected to the current sensors (14) and configured to digitize the measured currents;

a PC host (40) connected to the A-D converter and configured to process the digitized measured currents to:

create initial current information indicative of initial normal operation of the system wherein the initial current information includes: a normalized correlation frequency spectrum derived from the cross power spectrum of the at least two phases; a non-trivial frequency spectrum derived from the normalized frequency spectrum; and a root-mean-square calculated from the non-trivial frequency spectrum;

make an initial threshold determination of a normal operation of the system, by performing an initial threshold check whereby the root mean-square of the non-trivial spectrum is compared to a threshold value derived from the current database, using the PC host (40), and stopping and giving an indication of a fault/abnormal system operation if the initial threshold check is not successful;

perform training and modeling of the system, following the successful initial determination of normal operation of the system, to yield modeled current information; and

monitor the system with instant current measurements to yield instant current information indicative of instant operation status of the system

wherein the monitoring system is configured to make a determination of instant operation status of the system based on a comparison of the instant current information with the modeled current information.

9. The monitoring system (10) of claim 8, wherein the indication of initial normal operation of the system is completable in a time period ranging substantially from 30 to 180 minutes.

10. The monitoring system (10) of claim 8, wherein modeled current information includes; a coefficient vector and; a training feature table.

11. The monitoring system (10) of claim 10, wherein instant current information includes and an instant feature table.

12. The monitoring system (10) of claim 11, wherein a residual energy is calculable, based on the instant current information and the modeled current information.

13. The monitoring system (10) of claim 12, wherein the instant operation status of the system is determinable based upon a comparison of the residual energy and at least one threshold.

**Patentansprüche**

1. Verfahren zum Überwachen eines Systems mit einer elektrischen Verbindung, wobei die Verbindung zumindest zwei Phasen und jeweilige Ströme aufweist, wobei das System ein periodisches Verhalten aufweist, wobei das Verfahren die folgenden Schritte umfasst:

Erstellen einer Stromwandler-zugehörigen Datenbasis entsprechend Komponentenmerkmalen des ordnungsgemäßen Funktionierens des Systems, wobei die Stromdatenbasis während des Betriebs des Systems erstellt wird oder im Vorfeld von dem Betrieb des Systems; Verbinden von Sensoren (14), um jeweilige Ströme von zwei Phasen der elektrischen Verbindungen zu messen, und Übertragen der gemessenen Strominformationen zu einem PC-Host (40); Verwenden des PC-Host (40) zum Umwandeln der gemessenen Ströme und zum Erstellen anfänglicher Strominformationen, wobei die anfänglichen Strominformationen aufweisen: ein normalisiertes Korrelationsfrequenzspektrum, abgeleitet von dem Kreuzleistungsspektrum der zumindest zwei Phasen; ein nicht-triviales Frequenzspektrum, abgeleitet von dem normalisierten Frequenzspektrum; und eine Berechnung des quadratischen Mittelwertes des nicht-trivialen Frequenzspektrums;
Durchführen einer anfänglichen Bestimmung eines Normalbetriebs des Systems durch Durchführen einer anfänglichen Schwellenwertüberprüfung, wobei der quadratische Mittelwert des nicht-trivialen Frequenzspektrums mit einem Schwellenwert verglichen wird, der von der Stromdatenbasis abgeleitet ist, unter Verwendung des PC-Host (40), und Stoppen und Ausgeben einer Anzeige eines fehlerhaften/abnormalen Systembetriebs, wenn die anfängliche Schwellenwertüberprüfung nicht erfolgreich ist;
Betreiben den PC-Host (40), um Ausbildung und Modellierung des Systems durchzuführen, nachfolgend auf eine erfolgreiche anfängliche Bestimmung des Normalbetriebs des Systems, wobei die Ausbildung und die Modellierung des Systems weitere Strommessungen aufweist, die modellierte Strominformationen ergeben;
Überwachen des Systems, welches Durchführen von augenblicklichen Strommessungen des Systems aufweist und Verwenden des PC-Host (40), um augenblickliche Strominformationen zu erhalten, die den augenblicklichen Betriebsstatus des Systems anzeigen; und
Durchführen einer augenblicklichen Bestimmung des Betriebsstatus des Systems durch Verwenden des PC-Host (40), um die augenblicklichen Strominformationen mit den modellierten Strominformationen zu vergleichen.

2. Verfahren nach Anspruch 1, wobei keine Ausbildung, Modellierung und Überwachung des Systems durchgeführt wird, wenn die anfängliche Schwellenwertüberprüfung nicht erfolgreich ist.

3. Verfahren nach Anspruch 1, wobei das anfängliche Bestimmen des Normalbetriebs des Systems in einem Zeitraum, der im Wesentlichen in einem Bereich von 30 bis 180 Minuten liegt, abgeschlossen wird.

4. Verfahren nach Anspruch 3, wobei die modellierten Strominformationen einen Koeffizientenvektor und eine Ausbildungsmerkmaltabelle aufweisen.

5. Verfahren nach Anspruch 4, wobei die augenblicklichen Strominformationen eine augenblickliche Merkmaltabelle aufweisen.

6. Verfahren nach Anspruch 5, wobei eine Restenergie basierend auf den augenblicklichen Strominformationen und den modellierten Strominformationen berechnet wird und wobei die Restenergie mit zumindest einem Schwellenwert verglichen wird, um die augenblickliche Bestimmung des Betriebsstatus durchzuführen.

7. Verfahren nach Anspruch 1, wobei die Ausbildung und die Modellierung in einem Zeitraum, der im Wesentlichen in einem Bereich von 36 bis 100 Stunden liegt, abgeschlossen wird.

8. Überwachungssystem (10) zum Überwachen eines Systems mit einer elektrischen Verbindung, wobei die Verbindung zumindest zwei Phasen und jeweilige Ströme aufweist, wobei das System ein periodisches Verhalten aufweist, wobei das Überwachungssystem:

konfiguriert ist, um eine Stromwandler-zugehörige Datenbasis zu verwenden, die Komponentenmerkmalen des ordnungsgemäßen Funktionierens des Systems entspricht, wobei die Stromdatenbasis während des Betriebs des Systems erstellt wird oder im Vorfeld von dem Betrieb des Systems, wobei das Überwachungssystem umfasst:

zumindest zwei Stromsensoren (14), die konfiguriert sind, um mit den zumindest zwei Phasen verbunden zu werden und um jeweilige Ströme von den zumindest zwei Phasen zu messen;
einen A-zu-D-Wandler, der mit den Stromsensoren (14) verbunden ist und der konfiguriert ist, um die gemessenen Ströme zu digitalisieren;
einen PC-Host (40), der mit dem A-D-Wandler verbunden ist und der konfiguriert ist, um die digitalisierten gemessenen Ströme zu verarbeiten, zum:

Erstellen anfänglicher Strominformationen, die einen anfänglichen Normalbetrieb des Systems anzeigen, wobei die anfänglichen Strominformationen aufweisen: ein normalisiertes Korrelationsfrequenzspektrum, abgeleitet von dem Kreuzleistungsspektrum der zumindest zwei Phasen; ein nicht-triviales Frequenzspektrum, abgeleitet von dem normalisierten Frequenzspektrum; und einen quadratischen Mittelwert, berechnet von dem nicht-trivialen Frequenzspektrum;
Durchführen einer anfänglichen Schwellenwertbestimmung eines Normalbetriebs des Systems durch Durchführen einer anfänglichen Schwellenwertüberprüfung, wobei der quadratische Mittelwert des nicht-trivialen Frequenzspektrums mit einem Schwellenwert verglichen wird, der von der Stromdatenbasis abgeleitet ist, unter Verwendung des PC-Host (40), und Stoppen und Ausgeben einer Anzeige eines fehlerhaften/abnormalen Systembetriebs, wenn die anfängliche Schwellenwertüberprüfung nicht erfolgreich ist;
Durchführen von Ausbildung und Modellierung des Systems, nachfolgend auf eine erfolgreiche anfängliche Bestimmung des Normalbetriebs des Systems, um modellierte Strominformationen zu erhalten;
Überwachen des Systems mit augenblicklichen Strommessungen, um augenblickliche Strominformationen zu erhalten, die den augenblicklichen Betriebsstatus des Systems anzeigen;
wobei das Überwachungssystem konfiguriert ist, um eine Bestimmung des augenblicklichen Betriebsstatus des Systems durchzuführen, basierend auf einem Vergleich der augenblicklichen Strominformationen mit den modellierten Strominformationen.

9. Überwachungssystem (10) nach Anspruch 8, wobei das Anzeigen des anfänglichen Normalbetriebs des Systems in einem Zeitraum, der im Wesentlichen in einem Bereich von 30 bis 180 Minuten liegt, abschließbar ist.

10. Überwachungssystem (10) nach Anspruch 8, wobei die modellierten Strominformationen einen Koeffizientenvektor und eine Ausbildungsmerkmaltabelle aufweisen.

11. Überwachungssystem (10) nach Anspruch 10, wobei die augenblicklichen Strominformationen auch eine augenblickliche Merkmaltabelle aufweisen.

12. Überwachungssystem (10) nach Anspruch 11, wobei eine Resteenergie basierend auf den augenblicklichen Strominformationen und den modellierten Strominformationen berechenbar ist.

13. Überwachungssystem (10) nach Anspruch 12, wobei der augenblickliche Betriebsstatus des Systems basierend auf einem Vergleich der Restenergie mit zumindest einem Schwellenwert bestimmbar ist.

**Revendications**

1. Procédé de surveillance d'un système possédant une connexion électrique, la connexion possédant au moins deux phases et des courant respectifs, le système possédant un comportement périodique, le procédé comprenant les étapes consistant à :

créer une base de données de courant en rapport avec un transformateur correspondant aux caractéristiques des composants du fonctionnement adéquat du système, la base de données de courant étant créée pendant le fonctionnement du système ou créée préalablement au fonctionnement du système ;
connecter des capteurs (14) pour mesurer les courants respectifs des deux phases de la connexion électrique et transférer les informations de courant mesurées à un hôte PC (40) ;
utiliser l'hôte PC (40) pour transformer les courants mesurés et de façon à créer des informations de courant initial moyennant quoi les informations de courant initial comprennent : un spectre de fréquences de corrélation normalisé, dérivé du spectre de puissance croisé desdites au moins deux phases ; un spectre de fréquences non trivial dérivé du spectre de fréquences normalisé ; et un calcul de moyenne quadratique du spectre de fréquences non trivial ;
réaliser une détermination initiale d'un fonctionnement normal du système, en exécutant une vérification initiale de seuil, selon lequel la moyenne quadratique du spectre non trivial est comparée à une valeur seuil dérivée de la base de données de courant, en utilisant l'hôte PC (40), et arrêter et donner une indication d'une anomalie/d'un fonctionnement anormal du système si la vérification initiale de seuil n'est pas couronnée de succès ;
faire fonctionner l'hôte PC (40) pour exécuter un apprentissage et une modélisation du système, à la suite de la détermination initiale couronnée de succès du fonctionnement normal du système, l'apprentissage et la modélisation du système comprenant d'autres mesures de courant donnant des informations de courant modélisé ;
surveiller le système, ce qui comprend l'exécution de mesures de courant instantané du système et l'utilisation de l'hôte PC (40) pour donner des informations de courant instantané indicatives de l'état de fonctionnement instantané du système ; et
réaliser une détermination instantanée de l'état de fonctionnement du système en utilisant l'hôte PC (40) pour comparer les informations de courant instantané aux informations de courant modélisé.

2. Procédé selon la revendication 1, selon lequel aucun apprentissage, modélisation et surveillance du système n'est exécuté lorsque la vérification initiale de seuil n'est pas couronnée de succès.

3. Procédé selon la revendication 1, selon lequel la détermination initiale du fonctionnement normal du système est achevée dans un laps de temps allant sensiblement de 30 à 180 minutes.

4. Procédé selon la revendication 3, selon lequel les informations de courant modélisé comprennent un vecteur de coefficient et une table de caractéristiques d'apprentissage.

5. Procédé selon la revendication 4, selon lequel les informations de courant instantané comprennent une table de caractéristiques instantanées.

6. Procédé selon la revendication 5, selon lequel une énergie résiduelle est calculée sur la base des informations de courant instantané et des informations de courant modélisé et l'énergie résiduelle est comparée à au moins un seuil pour réaliser la détermination instantanée de l'état de fonctionnement.

7. Procédé selon la revendication 1, selon lequel l'apprentissage et la modélisation sont achevés dans un laps de temps allant sensiblement de 36 à 100 heures

8. Système de surveillance (10) pour la surveillance d'un système possédant une connexion électrique, la connexion possédant au moins deux phases et des courants respectifs, le système possédant un comportement périodique, le système de surveillance :

étant configuré pour utiliser une base de données de courant en rapport avec un transformateur correspondant à des caractéristiques des composants du fonctionnement adéquat du système, la base de données de courant étant créée pendant le fonctionnement du système ou créée préalablement au fonctionnement du système, le système de surveillance comprenant :

au moins deux capteurs de courant (14) configurés pour être connectés auxdites au moins deux phase et pour mesurer les courants respectifs desdites au moins deux phases ;
un convertisseur analogique vers numérique connecté aux capteurs de courant (14) et configuré pour numériser les courants mesurés ;
un hôte PC (40) connecté au convertisseur analogique vers numérique et configuré pour traiter les courants mesurés numérisés pour :

créer des informations de courant initial indicatives du fonctionnement normal initial du système, dans lequel les informations de courant initial comprennent : un spectre de fréquences de corrélation normalisé, dérivé du spectre de puissance croisé desdites au moins deux phases ; un spectre de fréquences non trivial dérivé du spectre de fréquences normalisé ; et une moyenne quadratique calculée à partir du spectre de fréquences non trivial ;

réaliser une détermination initiale de seuil d'un fonctionnement normal du système, en exécutant une vérification initiale de seuil selon lequel la moyenne quadratique du spectre non trivial est comparée à une valeur seuil dérivée de la base de données de courant, à l'aide de l'hôte PC (40), et arrêter et donner une indication d'une anomalie/un fonctionnement anormal du système si la vérification initiale de seuil n'est pas couronnée de succès ;

exécuter un apprentissage et une modélisation du système, à la suite de la détermination initiale couronnée de succès du fonctionnement normal du système, pour donner des informations de courant modélisé ; et

surveiller le système avec des mesures de courant instantané pour donner des informations de courant instantané indicatives de l'état de fonctionnement instantané du système,

dans lequel le système de surveillance est configuré pour réaliser une détermination de l'état de fonctionnement instantané du système sur la base d'une comparaison des informations de courant instantané aux informations de courant modélisé.

9. Système de surveillance (10) selon la revendication 8, dans lequel l'indication de fonctionnement normal initial du système peut être achevée dans un laps de temps allant sensiblement de 30 à 180 minutes.

10. Système de surveillance (10) selon la revendication 8, dans lequel les informations de courant modélisé comprennent ; un vecteur de coefficient et ; une table de caractéristiques d'apprentissage.

11. Système de surveillance (10) selon la revendication 10, dans lequel les informations de courant instantané comprennent une table de caractéristiques instantanées.

12. Système de surveillance (10) selon la revendication 11, dans lequel une énergie résiduelle est calculable, sur la base des informations de courant instantané et des informations de courant modélisé.

13. Système de surveillance (10) selon la revendication 12, dans lequel l'état de fonctionnement instantané du système est déterminable sur la base d'une comparaison de l'énergie résiduelle et d'au moins un seuil.

Prior Art

FIG 1

FIG 2

EP 2 885 646 B1

FIG 3

100

102
Phase 1 recording

104
Phase 2 recording

106
Phase 1 integration

108
Phase 1 integration

110
Phase 1 high-pass filtering

112
Phase 2 high-pass filtering

Next recording process

114
2 Phase current data

116
Validity Test
RMS & KURTOSIS

no

yes

118
Feature Extraction
Class I

124
Stop/recheck

yes

120
C > initial
threshold?

no

122
PROCEED

FIG 4

FIG 5

FIG 6

FIG 7

FIG 8

FIG 9

FIG 10

FIG 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 04017038 A
- WO 0004359 A
- US 6014598 A, Duyar Ahmet
- US 6713978 B, Parlos Alexander
- US 20030065634 A
- US 6590362 B, Parlos
- US 20030067277 A
- US 7024335 B
- EP 1298511 A
- US 5576632 A

### Non-patent literature cited in the description

- Induction Machine Broken Bar and Stator Short-Circuit Fault Diagnostics Based on Three-Phase Stator Current Envelopes. **DA SILVA A M et al.** IEEE TRANSACTIONS ON INDUSTRIAL ELECTRONICS. IEEE SERVICE CENTER, 01 March 2008, vol. 55, 1310-1318
- **GHASEMI SHERMINAH.** *Ryerson University An Application Of A Hybrid Wavelet-SVM Based Approach For Induction Motor Fault Detection,* 01 January 2010